Europäisches Patentamt

European Patent Office

Office européen des brevets

(19)

(11) **EP 0 844 944 B1**

(12) **EUROPÄISCHE PATENTSCHRIFT**

(45) Veröffentlichungstag und Bekanntmachung des Hinweises auf die Patenterteilung:
**10.10.2001 Patentblatt 2001/41**

(51) Int Cl.⁷: **B60R 21/00**, B60R 16/02

(21) Anmeldenummer: **96910908.1**

(22) Anmeldetag: **27.04.1996**

(86) Internationale Anmeldenummer:
**PCT/DE96/00739**

(87) Internationale Veröffentlichungsnummer:
**WO 97/06980 (27.02.1997 Gazette 1997/10)**

(54) **ANORDNUNG ZUM KONTROLLIEREN DES WIDERSTANDES EINER AN EINEM ÜBERTRAGER ANGESCHLOSSENEN LAST**

SYSTEM FOR CONTROLLING THE RESISTANCE OF A LOAD CONNECTED TO A TRANSFORMER

SYSTEME DE CONTROLE DE LA RESISTANCE D'UNE CHARGE RACCORDEE A UN TRANSFORMATEUR

(84) Benannte Vertragsstaaten:
**DE FR GB IT SE**

(30) Priorität: **19.08.1995 DE 19530588**

(43) Veröffentlichungstag der Anmeldung:
**03.06.1998 Patentblatt 1998/23**

(73) Patentinhaber: **ROBERT BOSCH GMBH**
**70442 Stuttgart (DE)**

(72) Erfinder:
 • **DOBLER, Klaus**
   **D-70839 Gerlingen (DE)**
 • **ZABLER, Erich**
   **D-76297 Stutensee (DE)**
 • **DUKART, Anton**
   **D-76744 Wörth (DE)**
 • **HERRMANN, Thomas**
   **D-74243 Langenbrettach (DE)**

(56) Entgegenhaltungen:
DE-A- 3 540 031          DE-A- 3 812 633

## Beschreibung

Stand der Technik

Die vorliegende Erfindung betrifft eine Anordnung zum Kontrollieren des Widerstandes einer an einem Übertrager sekundärseitig angeschlossenen Last - vorzugsweise der Zündpille eines Airbags.

Eine derartige Anordnung ist aus der DE 38 12 633 A1 bekannt. Gemäß diesem Stand der Technik wird beispielsweise zur Signalübertragung zwischen einem Steuergerät und einem in einem Lenkrad eines Fahrzeugs eingebauten Airbag ein Drehübertrager verwendet. Die Funktionsfähigkeit eines Airbags ist ständig zu überprüfen, damit er in jeder Notfallsituation sofort einsatzbereit ist. Dazu wird der Widerstand der Zündpille, der typischerweise im Bereich von 1,8 Ohm bis 2,5 Ohm liegen soll, einer ständig wiederkehrenden Messung unterzogen. Die Übertragung von Signalen mittels der induktiv gekoppelten Wicklungen des Drehübertragers ist vom Abstand der beiden Wicklungen, d. h. der Größe des Luftspalts zwischen den Schalenkernen der Wicklungen, abhängig. Einbau- und Fertigungstoleranzen des Lenkrades, an dem der sekundärseitige Schalenkern des Drehübertragers installiert ist, können zu einer Verfälschung des gemessenen Widerstandswertes der Zündpille führen. Um solche Meßsignalverfälschungen zu vermeiden, sieht der genannte Stand der Technik einen Schwingkreis auf der Sekundärseite des Drehübertragers vor, der von der Primärseite aus von einem Steuersignal angeregt wird. Nach Abschalten des Steuersignals wird das Abklingen des Antwortsignals des Schwingkreises auf die Primärseite zurückübertragen und aus der Zeitkonstanten des abklingenden Antwortsignals der sekundärseitige Widerstand ermittelt.

Vorteile der Erfindung

Gemäß Anspruch 1 wird der Widerstand einer an einem Übertrager sekundärseitig angeschlossenen Last - vorzugsweise der Zündpille eines Airbags - dadurch auf Abweichung von einem vorgegebenen Wert kontrolliert, daß primärseitig ausschließlich die Induktivität des Übertragers gemessen wird. Dieser Maßnahme liegt die Erkenntnis zugrunde, daß die primärseitig gemessene Induktivität eine eindeutige Abhängigkeit von einem sekundärseitig angeschlossenen Lastwiderstand zeigt. Wird also eine Abweichung der gemessenen Induktivität von einem bestimmten Wert festgestellt, so läßt sich daraus ableiten, daß sich der Lastwiderstand geändert hat. Eine Verschiebung der Induktivität kann also zum Anlaß genommen werden, um eine fehlerhafte Änderung der Last zu signalisieren.

Zweckmäßige Ausbildungen der Erfindung gehen aus den Unteransprüchen hervor. Danach ist in den Primärkreis des Übertragers ein Meßwiderstand eingesetzt, der sehr viel größer ist als der primärseitige Eingangswiderstand des Übertragers. Der Übertrager wird primärseitig von einer impulsförmigen Kontroll-Spannung gespeist und die Anstiegs- und/oder Abfallzeitkonstante einer an dem Meßwiderstand abfallenden Meßspannung ermittelt. Diese Zeitkonstante ist nahezu ausschließlich von der primärseitigen Induktivität des Übertragers abhängig, welche einen eindeutigen Zusammenhang zum Lastwiderstand herstellt. Der Übertrager-Eingangswiderstand, welcher keine eindeutige Abhängigkeit vom Lastwiderstand zeigt, hat somit keinen Einfluß auf die gemessene Zeitkonstante. Die gemessene Zeitkonstante gibt also eindeutig Auskunft darüber, ob die Last aufgrund einer Fehlfunktion ihren Widerstand geändert hat. Es ist zweckmäßig, die Pulsfrequenz der impulsförmigen Kontroll-Spannung so zu wählen, daß die primärseitig gemessene Induktivität des Übertragers für einen fehlerfreien Lastwiderstand eine möglichst geringe Abhängigkeit von einer Änderung der Kopplung zwischen der Primär- und der Sekundärwicklung des Übertragers zeigt.

Beschreibung eines Ausführungsbeispiels

Anhand eines in der Zeichnung dargestellten Ausführungsbeispiels wird nachfolgend die Erfindung näher erläutert. Figur 1 zeigt einen Übertrager mit einer daran angeschlossenen Last. Figur 2 zeigt ein primärseitiges Ersatzschaltbild eines Übertragers mit daran angeschlossenen Einrichtungen zum Ermitteln der Induktivität des Übertragers. Figur 3 zeigt einen auf der Primärseite des Übertragers gemessenen Spannungsverlauf. Figur 4 zeigt die Abhängigkeit der Übertragerinduktivität von einem sekundärseitig angeschlossenen Lastwiderstand.

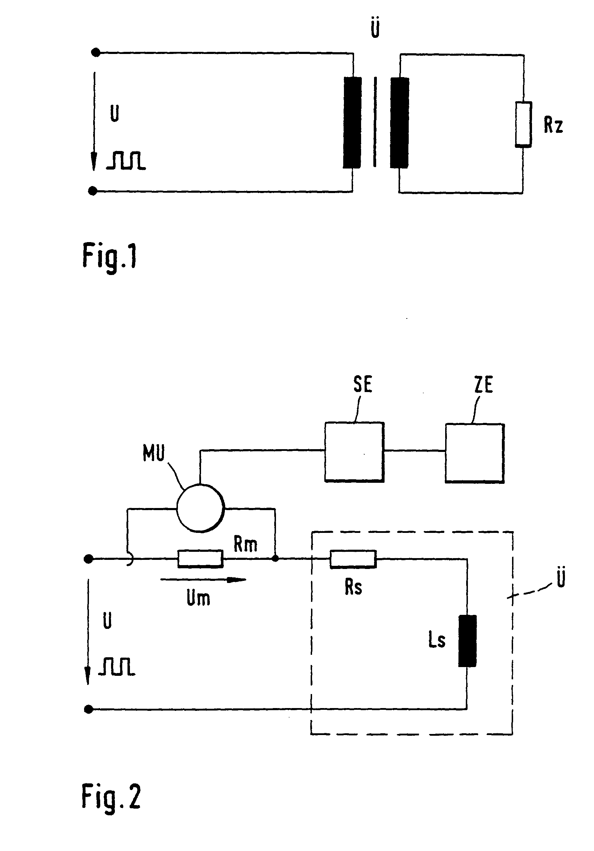

Wie einleitend dargelegt, soll von der Primärseite eines Übertragers her ein an dessen Sekundärseite angeschlossener Lastwiderstand auf Änderung hin kontrolliert werden. In der Figur 1 ist das Prinzipschaltbild eines Übertragers Ü und eines daran sekundärseitig angeschlossenen Lastwiderstandes Rz dargestellt. Der Übertrager Ü sei beispielsweise ein Drehübertrager, der zwischen einem mit einem Airbag ausgestatteten Lenkrad und der feststehenden Lenksäule angeordnet ist. Die sekundärseitig angeschlossene Last Rz entspricht dann dem Widerstand einer Zündpille des Airbag. Eine solche Zündpille hat im Normalfall einen Widerstand Rz von ca. 2 Ohm. Ändert sich der Widerstand der Zündpille über gewisse Grenzwerte hinaus, so deutet das darauf hin, daß die Funktion des Airbags gestört ist. Eine solche Situation muß im Fahrzeug signalisiert werden. Die Kontrolle des Zündpillenwiderstandes Rz wird stetig wiederkehrend durchgeführt.

Von der Primärseite des Übertragers Ü her gesehen hat er das in Figur 2 strichliert umrandete Ersatzschaltbild, bestehend aus einem Widerstand Rs und einer Induktivität Ls. In Reihe zum Widerstand Rs ist ein Meßwiderstand Rm geschaltet. Ein Spannungsmeßgerät Mu mißt die an dem Meßwiderstand Rm abfallende Meßspannung Um. Am primärseitigen Eingang des Übertragers Ü liegt eine impulsförmige Kontroll-Spannung U an.

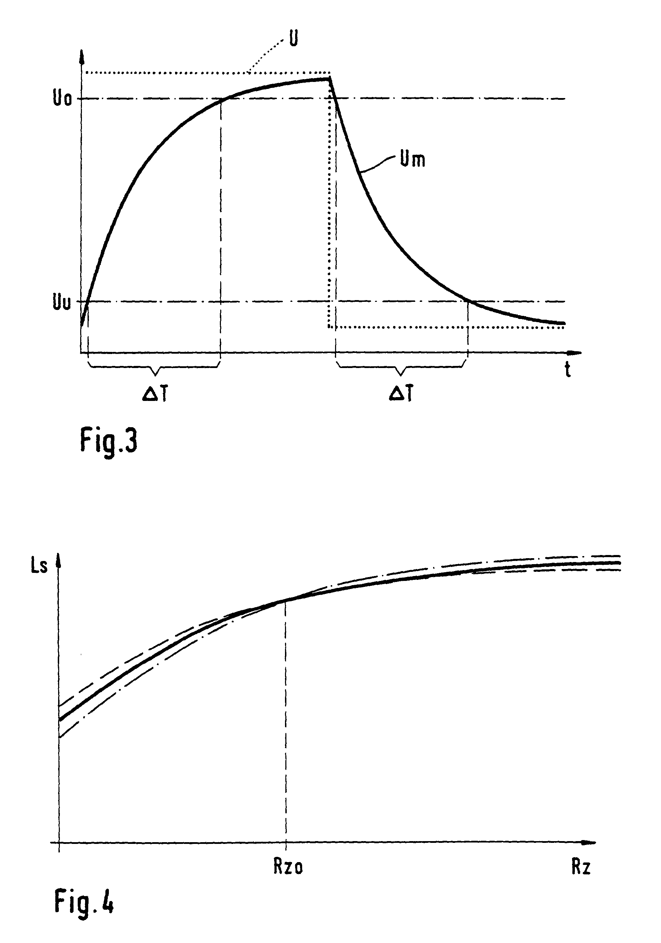

In der Figur 3 ist der Verlauf der Meßspannung Um als Reaktion auf einen Impuls der Kontroll-Spannung U dargestellt. Sowohl der Anstieg als auch der Abfall der Meßspannung Um erfolgt mit einer Zeitkonstanten τ. Diese Zeitkonstante τ hängt auf folgende Weise von der Induktivität Ls und den Widerständen Rs und Rm ab:

$$\tau = \frac{Ls}{Rs + Rm} \tag{1}$$

Es zeigt sich, daß die Anstiegs- bzw. Abfallzeitkonstante τ sowohl von der Induktivität Ls als auch dem Widerstand Rs des Übertragers abhängt. Sowohl die Induktivität Ls als auch der Widerstand Rs des Übertragers zeigen eine Abhängigkeit von dem sekundärseitig angeschlossenen Lastwiderstands Rz. Die Abängigkeit des Widerstandes Rs vom Lastwiderstand Rz ist aber nicht eindeutig. Deshalb wird der Meßwiderstand Rm so groß gewählt (mindesten 10mal so groß wie Rs), daß der Einfluß des Widerstandes Rs bei der Zeitkonstanten τ nahezu verschwindet. Die Anstiegs- bzw. Abfallzeitkonstante τ der Meßspannung Um ist dann nahezu nur noch von der Induktivität Ls des Übertragers abhängig.

$$\tau \approx \frac{Ls}{Rm} \tag{2}$$

$$\tau \approx \frac{Ls}{Rm}$$

Der Verlauf der Meßspannung Um im Anstiegszweig läßt sich beschreiben durch

$$m(t) = Rm \cdot I \cdot \left( 1 - e^{-t\left(\frac{1}{\tau}\right)} \right) \tag{3}$$

Der Verlauf der Meßspannung Um im abfallenden Zweig läßt sich beschreiben durch

$$m(t) = Rm \cdot I \cdot e^{-t\left(\frac{1}{\tau}\right)} \tag{4}$$

Die Anstiegs- bzw. Abfallzeitkonstante τ läßt sich auf folgende Weise ermitteln. Die Meßspannung Um wird einem Schwellwertentscheider SE zugeführt (siehe Figur 2). Wie der Figur 3 zu entnehmen ist, besitzt dieser Schwellwertentscheider eine untere Schwelle Uu und eine obere Schwelle Uo für die Meßspannung Um. Sobald die Meßspannung Um die untere Schwelle Uu überschreitet, wird ein Zähler in einer Zeiterfassungseinheit ZE gestartet. Sobald die Meßspannung die obere Schwelle Uo erreicht, wird der Zähler gestoppt. Der erreichte Zählerstand ist dann proporional zu der Anstiegszeitkonstanten τ. Soll die Zeitkonstante τ im abfallenden Verlauf der Meßspannung ermittelt werden, so wird auf ähnliche Weise die Zeit zwischen Unterschreiten der oberen Spannungsschwelle Uo und Erreichen der unteren Spannungsschwelle Uu ermittelt. Die obere und die untere Spannungsschwelle lassen sich folgendermaßen beschreiben:

$$o = U\left( 1 - e^{-\Delta T\left(\frac{1}{\tau}\right)} \right) \tag{5}$$

$$u = U \cdot e^{-\Delta T\left(\frac{1}{\tau}\right)} \qquad\qquad (6)$$

$\Delta$T bezeichnet die von der Zeiterfassungseinheit Ze ermittelte Zeit beim Übergang der Meßspannung zwischen den beiden Spannungsschwellen Uu und Uo (vgl. Fig.3). Aus der Gleichung (5) ergibt sich für die Zeitkonstante:

$$\tau = \frac{-\Delta T}{\ln\left(\frac{Uo+U}{U}\right)} \qquad\qquad (7)$$

Aus der Gleichung (6) ergibt sich die Zeitkonstante:

$$\tau = \frac{-\Delta T}{\ln\left(\frac{Uu}{U}\right)} \qquad\qquad (8)$$

Um die Genauigkeit bei der Ermittlung der Zeitkonstante $\tau$ zu steigern, ist es zweckmäßig, für eine Vielzahl von Impulsen der Kontroll-Spannung U die Zeitkonstante $\tau$ nach dem vorherbeschriebenen Verfahren zu bestimmen und einen Mittelwert daraus zu bilden. Gemäß Gleichung (2) ergibt sich nun für die Induktivität Ls des Übertragers:

$$Ls = \tau \cdot Rm \qquad\qquad (9)$$

In der Figur 4 ist die Abhängigkeit der primärseitig gemessenen Induktivität Ls vom sekundärseitig an den Übertrager angeschlossenen Lastwiderstand Rz dargestellt. Diese Abhängigkeit ist eindeutig. Die beiden oberhalb und unterhalb der durchgezogenen Kennlinie eingezeichnenten Kennlinien für die Induktivität Ls ergeben sich bei einem axialen Versatz zwischen der Primär- und der Sekundärwicklung des Übertragers Ü. Die strichliert gezeichnete Kennlinie resultiert bei einem größeren Abstand zwischen den beiden Wicklungen, und die punkt-strichlierte Kennlinie ergibt sich bei einer Annäherung der beiden Wicklungen. Auffällig ist, daß sich alle Kennlinien in einem Punkt schneiden. Die Lage des Schnittpunktes hängt von der Pulsfrequenz der Kontroll-Spannung U ab. Wird die Pulsfrequenz der Kontroll-Spannung U erhöht, so verschiebt sich dieser Schnittpunkt zu einem höheren Lastwiderstand Rz hin. Die Pulsfrequenz der Kontroll-Spannung U wird nun so gewählt, daß der Schnittpunkt der Kennlinien gerade im Bereich eines Lastwiderstandes Rz0 liegt, den die Last bei einwandfreier Funktion hat. Die gemessene Induktivität Ls wird dann bei ungestörter Last einen vom axialen Versatz der Übertragerwicklungen unabhängigen ,konstanten Wert haben. Erst wenn eine von diesem konstanten Wert abweichende Induktivität Ls ermittelt wird, läßt sich daraus auf eine Fehlfunktion der Last schließen. Weil sich also die Induktivität Ls beim Widerstand Rz0 der ungestörten Last auf einem konstanten Wert hält, kann durch einen axialen Versatz der Übertragerwicklungen nicht fälschlicherweise auf eine Störung der Last geschlossen werden.

## Patentansprüche

1. Anordnung zum Kontrollieren des Widerstandes einer an einem Übertrager (Ü) sekundärseitig angeschlossenen Last (Rz) - vorzugsweise der Zündpille eines Airbags -, **dadurch gekennzeichnet, daß** Mittel (Mu, SE, ZE) vorhanden sind, welche primärseitig ausschließlich die Induktivität (Ls) des Übertragers (Ü) messen und bei Abweichung von einem vorgegebenen Wert einen Fehler der Last signalisieren.

2. Anordnung nach Anspruch 1, **dadurch gekennzeichnet, daß** der Übertrager (Ü) eine Primär- und eine Sekundärwicklung aufweist, die um eine gemeinsame Achse gegeneinander verdrehbar sind.

3. Anordnung nach Anspruch 1, **dadurch gekennzeichnet, daß** in den Primärkreis des Übertragers (Ü) ein Meßwiderstand (Rm) eingesetzt ist, der mindestens 10mal so groß ist wie der primärseitige Eingangswiderstand (Rs) des Übertragers (Ü), und daß Schaltmittel (SE, ZE) vorhanden sind, welche die Anstiegs- und/oder Abfallzeitkonstante einer an dem Meßwiderstand (Rm) abfallenden Meßspannung (Um) ermitteln, wenn der Übertrager (Ü) primärseitig von einer impulsförmigen Kontroll-Spannung (U) gespeist wird.

4. Anordnung nach Anspruch 3, **dadurch gekennzeichnet, daß** die Schaltungsmittel für die Ermittlung der Anstiegs- und/oder Abfallzeitkonstante einen Schwellwertentscheider (SE) und eine Zeiterfassungseinheit (ZE) aufweisen, welche die Übergangszeit der Meßspannung (Um) zwischen einem unteren und einem oberen (bzw. umgekehrt) Schwellenwert (Uu, Uo) mißt.

5. Anordnung nach Anspruch 3 oder 4, **dadurch gekennzeichnet, daß** die Schaltungsmittel (SE, ZE) aus den Anstiegs- und/oder Abfallzeitkonstanten mehrerer Meßspannungsimpulse (Um) eine mittlere Anstiegs- und/oder Abfallzeitkonstante ermitteln.

6. Anordnung nach einem der vorhergehenden Ansprüche, **dadurch gekennzeichnet, daß** die Pulsfrequenz der impulsförmigen Kontroll-Spannung (U) so gewählt ist, daß die primärseitig gemessene Induktivität (Ls) des Übertragers (Ü) für einen fehlerfreien Lastwiderstand (Rz) eine möglichst geringe Abhängigkeit von einer Änderung der Kopplung zwischen der Primär- und der Sekundärwicklung des Übertragers (Ü) zeigt.

## Claims

1. Arrangement for monitoring the resistance of a load (Rz) - preferably the firing pellet of an airbag - connected to the secondary side of a transformer (Ü), **characterized in that** means (Mu, SE, ZE) are present which, on the primary side, measure exclusively the inductance (Ls) of the transformer (Ü) and signal a load fault in the event of deviation from a predetermined value.

2. Arrangement according to Claim 1, **characterized in that** the transformer (U) has a primary winding and a secondary winding which can be rotated relative to one another about a common axis.

3. Arrangement according to Claim 1, **characterized in that** a measuring resistor (Rm), which is at least 10 times as large as the primary-side input resistance (Rs) of the transformer (Ü) is inserted into the primary circuit of the transformer (Ü), and **in that** switching means (SE, ZE) are present which determine the rise and/or fall time constant of a measurement voltage (Um) dropped across the measuring resistor (Rm) when the transformer (Ü) is fed by a pulsed monitoring voltage (U) on the primary side.

4. Arrangement according to Claim 3, **characterized in that** the circuit means for determining the rise and/or fall time constant have a threshold value decision unit (SE) and a time acquisition unit (ZE) which measures the transition time of the measurement voltage (Um) between a lower and an upper (or vice versa) threshold value (Uu, Uo).

5. Arrangement according to Claim 3 or 4, **characterized in that** the circuit means (SE, ZE) determine a mean rise and/or fall time constant from the rise and/or fall time constants of a plurality of measurement voltage pulses (Um).

6. Arrangement according to one of the preceding claims, **characterized in that** the pulse frequency of the pulsed monitoring voltage (U) is chosen such that the inductance (Ls) of the transformer (Ü) measured on the primary side exhibits, for a fault-free load resistance (Rz), the smallest possible dependence on a change of the coupling between the primary and secondary windings of the transformer (Ü).

## Revendications

1. Dispositif pour contrôler la résistance d'une charge (Rz) reliée au secondaire d'un transformateur (Ü) de préférence l'amorce d'allumage d'un coussin gonflable,
**caractérisé par**
des moyens (Mu, SE, ZE) qui mesurent du côté primaire exclusivement l'inductance (Ls) du transformateur (Ü) et en cas de différence par rapport à une valeur prédéterminée, signalent un défaut de la charge.

2. Dispositif selon la revendication 1,
**caractérisé en ce que**
le transformateur (Ü) comporte un primaire et un secondaire qui tournent autour d'un axe commun.

3. Dispositif selon la revendication 1,

**caractérisé en ce que**
le primaire du transformateur (U) comporte une résistance de mesure (Rm) qui est au moins 10 fois supérieure à la résistance d'entrée (Rs) du primaire du transformateur (Ü) et, des moyens de commutation (SE, ZE) sont prévus pour déterminer la constante de temps de montée et/ou de descente d'une tension de mesure (Um) aux bornes de la résistance de mesure (Rm), lorsque le transformateur (Ü) est alimenté du côté primaire par une tension de commande impulsionnelle (U).

4. Dispositif selon la revendication 3,
**caractérisé en ce que**
les moyens de commutation comprennent un décideur à seuil pour déterminer la constante de temps de montée et/ou de descente (SE) et une unité de saisie de temps (ZE) qui mesure le temps de passage de la tension de mesure (Um) entre un seuil inférieur et un seuil supérieur (Uu, Uo),ou inversement.

5. Dispositif selon la revendication 3 ou 4,
**caractérisé en ce que**
les moyens de commutation (SE, ZE) déterminent une constante de temps de montée et/ou de descente à partir des constantes de temps de montée et/ou de descente de plusieurs impulsions de mesure (Um).

6. Dispositif selon l'une des revendications précédentes,
**caractérisé en ce que**
la fréquence impulsionnelle de la tension de commande impulsionnelle (U) est choisie pour que l'inductance (Ls) du transformateur (U) mesurée du côté du primaire présente pour une résistance de charge (Rz) sans défaut, une dépendance aussi faible que possible d'une variation du couplage entre le primaire et le secondaire du transformateur (U).

Ü

U

Rz

**Fig.1**

SE

ZE

MU

Rm

Um

Rs

U

Ls

Ü

**Fig.2**

Fig.3

Fig.4